# EUROPEAN PATENT SPECIFICATION

(11) **EP 4 025 031 B1**
(45) Date of publication and mention of the grant of the patent: **08.01.2025**
(21) Application number: 19943415.0
(22) Date of filing: 30.08.2019
(51) Int. Cl.: H05K 13/08

(54) **WORK MACHINE**
ARBEITSMASCHINE
MACHINE DE TRAVAIL

(43) Date of publication of application: 06.07.2022
(73) Proprietor: Fuji Corporation, Chiryu-shi, Aichi 472-8686 (JP)
(72) Inventor: MATSUDA, Futoshi, Chiryu-shi, Aichi 472-8686 (JP)
(74) Representative: Grünecker Patent- und Rechtsanwälte PartG mbB
(86) International application number: PCT/JP2019/034206
(87) International publication number: WO 2021/038850

(56) References cited:
- EP-A1- 3 270 677
- EP-A1- 3 322 275
- EP-A1- 3 550 950
- EP-A1- 3 634 100
- WO-A1-2018/100706
- WO-A1-2018/220733
- WO-A1-2018/220733
- JP-A- 2014 203 938
- JP-A- H08 195 599

## Description

### Technical Field

The present application relates to a work machine including a holding head having a component holding tool.

### Background Art

In a work machine, there is a work machine including a holding head having a component holding tool. In such a work machine, as described in Patent Literature 1, a component held by the component holding tool is imaged by an imaging device, and a position of the component is calculated based on image data. Then, a component mounting work and the like are executed using the calculated position of the component.

If the mounting target component is a lead component having leads, the conventional work machine described above illuminates a tip of the lead with side illumination, and images the reflection light using the imaging device of a part camera positioned below lead component, and then, calculates the position of the tip of the lead based on the image data obtained by the imaging.

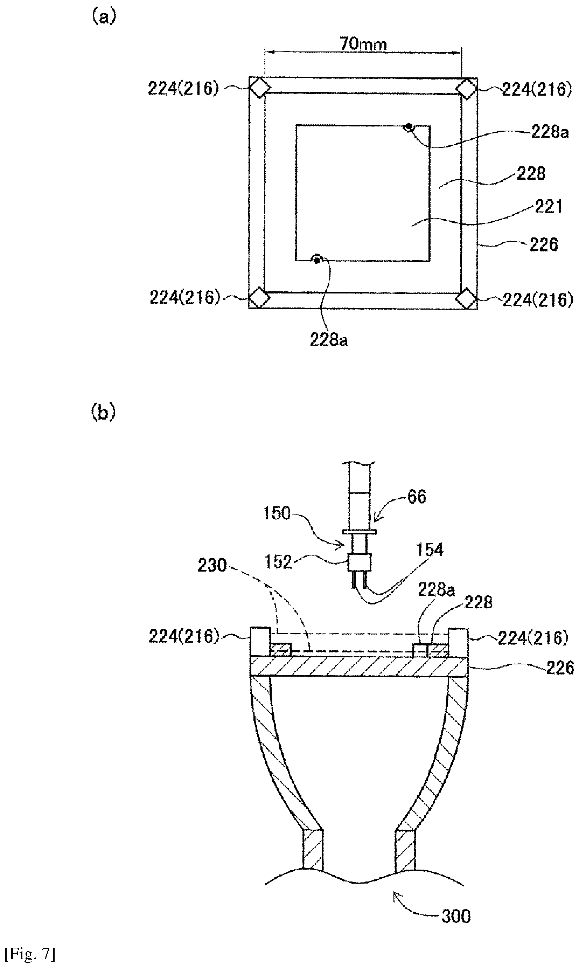

Fig. 7(a) shows a plan view of part camera 300 provided in the conventional work machine described above and Fig. 7(b) shows a cross-sectional view of an upper portion of part camera 300. Rectangular plate member 226 is arranged on an upper edge of part camera 300, and each of four laser lights 224 is arranged at four corners of plate member 226 toward the direction of irradiating a center portion with the side illumination light. As shown in Fig. 7(a), plate member 226 is a member in which a part of a region including the center portion is transparent. The transparent region is formed in a rectangular shape and forms horizontal imaging region 221. Reference mark mounting plate 228 (made of glass) is arranged surrounding imaging region 221. Reference mark mounting plate 228 is configured to install reference mark 228a in imaging region 221 in order to image reference mark 228a using part camera 300.

When imaging the tip of lead 154 of lead component 150 using part camera 300, as shown in Fig. 7(b), after lead component 150 is moved above part camera 300, and lead component 150 is lowered such that lead 154 of lead component 150 falls within the irradiation range of side illumination 216 and within a depth of field of imaging device 110 (the range shown by a broken line in the drawing, hereinafter referred to as "vertical imaging range 230"). As described above, when the tip of lead 154 of lead component 150 falls within vertical imaging range 230, the light of side illumination 216, that is, the laser light of laser light 224, is reflected from the tip of lead 154, and the reflection light is incident on part camera 300. As a result, the tip of lead 154 is imaged by part camera 300. Then, position coordinates of the tip of lead 154 in the horizontal direction (XY-direction) are calculated based on the image data obtained by imaging.

In addition, before or after imaging of lead component 150 by part camera 300, reference mark 228a is imaged by part camera 300. The position coordinates of part camera 28 in the XY-direction are calculated based on the image data obtained by the imaging.

Patent Application WO 2018/100706 A1 relates to a work machine for mounting a component having a lead into a through hole, whereby the lead may be bent. A work machine includes work heads having a component holding tool for holding the component, and moving devices for moving the heads within the horizontal xy-plane and up-down along the vertical z-axis. A part camera includes an imaging device, a lens, and a vertical lighting and a lateral lighting. The work heads are moved such that the distal end of the component is irradiated from the side by the lateral lighting. A control device calculates the xy position of the component lead, based on captured image data of the distal end. A reference mark is formed on the lower surface of auxiliary plate of arm section that is part of component holding tool. Using the vertical lighting, the reference mark is irradiated from the bottom, and the controller calculates the xy position of reference mark from the captured image data of auxiliary plate. Then, the spacing distance between the distal end and the reference mark is calculated, and the component is mounted if the spacing distance is smaller than a threshold.

### Patent Literature

Patent Literature 1: International Publication No. WO 2018/220733 A1

### Summary of the Invention

### Technical Problem

Incidentally, in the conventional work machine described above, since part camera 300 having a shallow depth of field is used, when lowering lead component 150 such that lead 154 falls within vertical imaging range 230, lead 154 of lead component 150 may interfere with reference mark 228a. In order to avoid this interference, it is necessary to lower lead component 150 to the region of imaging region 221 where reference mark 228a is not arranged. In the example in Fig. 7(b), since lead component 150 is smaller than imaging region 221, lead component 150 can be lowered to a region where lead 154 of lead component 150 does not interfere with reference mark 228a.

However, there is a demand to handle lead component 150 having the larger size, that is, a size exceeding imaging region 221. As a method for satisfying this demand, there is a method in which a part of lead entering imaging region 221 are sequentially imaged while moving lead component in the XY-direction in a state in which the lead falls within vertical imaging range 230, and then, the multiple image data obtained in this way are combined to create the image data for the entire lead. It is conceivable to apply this method to the conventional work machine described above, however, in the first place, since it is not possible to lower lead component larger than imaging region 221 to the position where the lead falls within vertical imaging range 230 due to the above interference problem, it is not so easy to directly apply this method to the conventional work machine described above.

Therefore, an object of the present application is to provide a work machine capable of handling a work target component having a size exceeding the imaging region.

### Solution to Problem

The above objective is achieved by the present invention defined by the features of the independent claim, with preferred embodiments being specified in the dependent claims. References to embodiments which do not fall under the scope of the claims are to be understood as examples useful for understanding the invention.

### Advantageous Effect of the Invention

According to the present application, even if a component is moved in the horizontal direction when imaging the component, since the component does not interfere with a reference mark, it is possible to calculate a position of a lead of the component having a larger size.

### Brief Description of Drawings

Fig. 1 is a perspective view showing a component mounter.
Fig. 2 is a perspective view of a component mounting device of the component mounter.
Fig. 3 is a block diagram showing a control device including the component mounter.
Fig. 4 is a schematic diagram showing a part camera.
Fig. 5(a) is a plan view and Fig. 5(b) shows a partial front view of part camera.
Fig. 6 is a diagram showing an image of image data created by combining divided data.
Fig. 7(a) is a plan view and Fig. 7(b) shows a partial front view of part camera included in the conventional component mounter.

### Description of Embodiments

Hereinafter, an embodiment of the present application will be described in detail with reference to the accompanying drawings.

### <Configuration of Component Mounter>

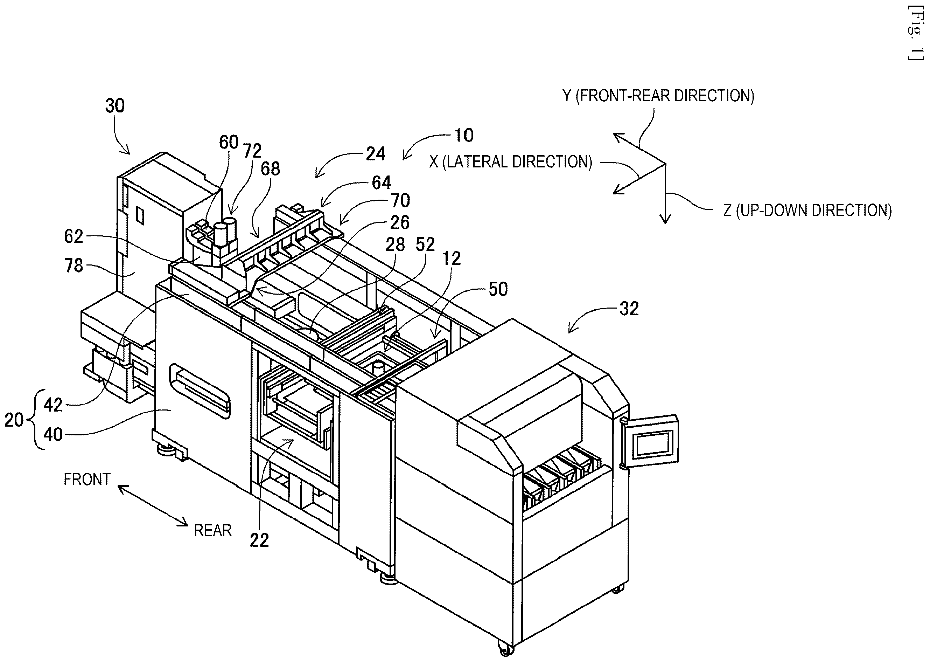

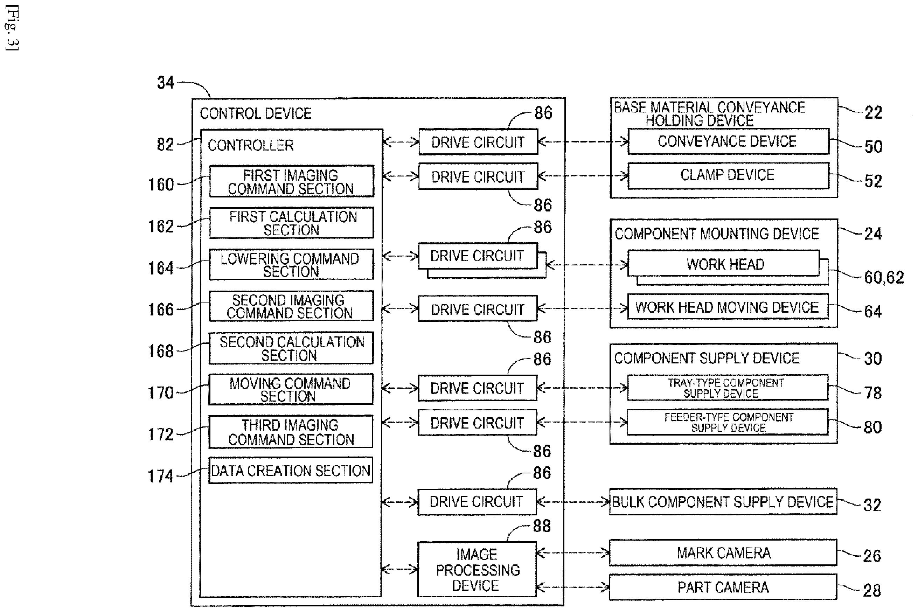

Fig. 1 shows component mounter 10. Component mounter 10 is a device for executing a mounting work of components on circuit base material 12. Component mounter 10 includes device main body 20, base material conveyance holding device 22, component mounting device 24, mark camera 26, part camera 28, component supply device 30, bulk component supply device 32, and control device 34 (refer to fig. 3). Examples of circuit base material 12 include a circuit board and a base material having a three-dimensional structure, and examples of the circuit board include a printed wiring board and a printed circuit board.

Device main body 20 is configured with frame section 40 and beam section 42 overlaid on frame section 40. Base material conveyance holding device 22 is arranged at the center of frame section 40 in the front-rear direction, and includes conveyance device 50 and clamp device 52. Conveyance device 50 is a device that conveys circuit base material 12, and clamp device 52 is a device that holds circuit base material 12. As a result, base material conveyance holding device 22 conveys circuit base material 12 and holds circuit base material 12 fixedly at a predetermined position. In the description below, the conveyance direction of circuit base material 12 is referred to as X-direction, the horizontal direction which is perpendicular to that direction is referred to as Y-direction, and the vertical direction is referred to as Z-direction. That is, the width direction of component mounter 10 is X-direction, and the front-rear direction is Y-direction.

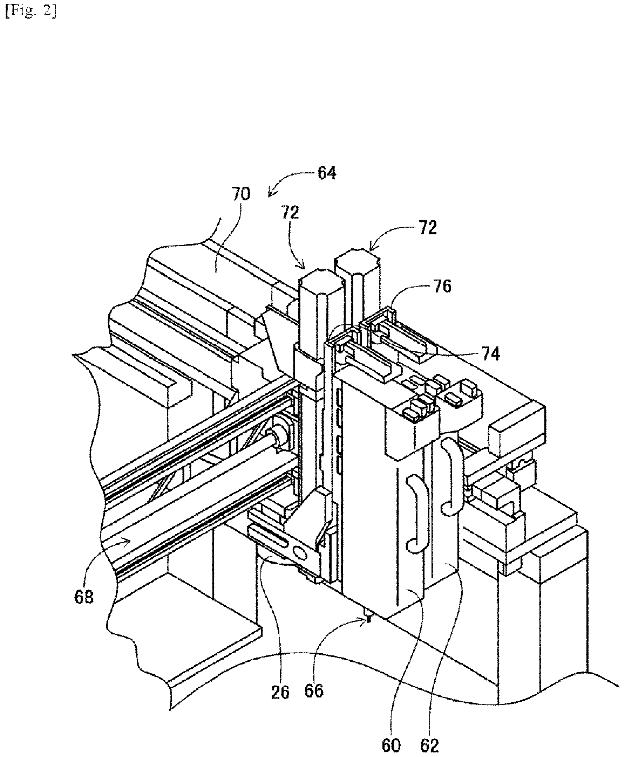

Component mounting device 24 is arranged in beam section 42 and includes two work heads 60 and 62 and work head moving device 64. As shown in Fig. 2, suction nozzles 66 are provided on the lower end surfaces of work heads 60 and 62, and suction nozzle 66 picks up and holds the component. Suction nozzle 66 is rotated by a rotating device driven by a motor (not illustrated) as a driving source, to adjust the orientation of the picked up and held component. In addition, work head moving device 64 includes X-direction moving device 68, Y-direction moving device 70, and Z-direction moving device 72. Then, two work heads 60 and 62 can be integrally moved to any position on frame section 40 by X-direction moving device 68 and Y-direction moving device 70. In addition, work heads 60 and 62 are detachably attached to sliders 74 and 76, and Z-direction moving device 72 individually moves sliders 74 and 76 in the up-down direction. That is, work heads 60 and 62 can be individually moved in the up-down direction by Z-direction moving device 72.

Mark camera 26 is attached to slider 74 in a state of facing downward, and can move in the X-direction, Y-direction and Z-direction together with work head 60. As a result, mark camera 26 images any position on frame section 40. As shown in Fig. 1, part camera 28 is arranged between base material conveyance holding device 22 and component supply device 30 on frame section 40 in a state of facing upward. As a result, part camera 28 images the components held by suction nozzles 66 of work heads 60 and 62.

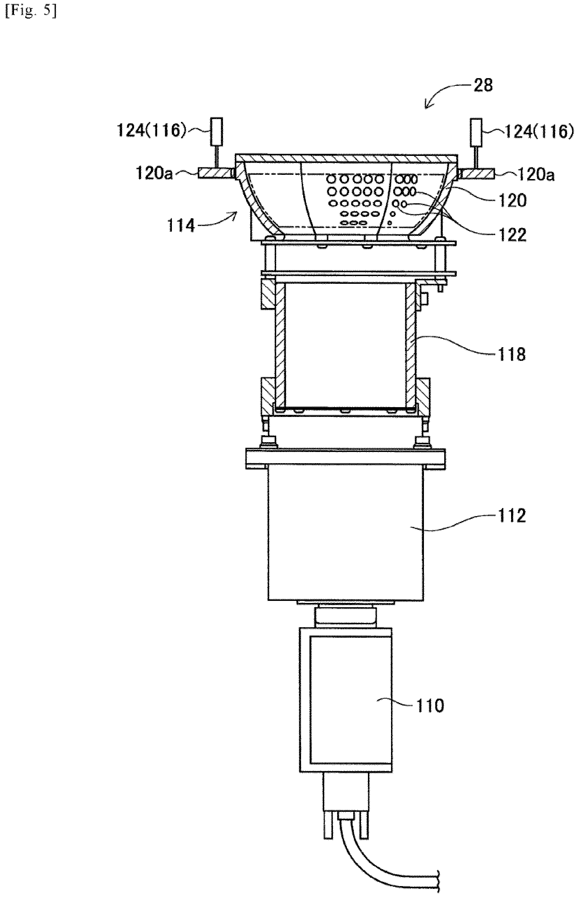

Specifically, as shown in Fig. 5, part camera 28 includes imaging device 110, lens 112, vertical illumination 114, and side illumination 116. The imaging device 110 includes an imaging element (not illustrated) and is arranged with the light receiving surface facing upward. Lens 112 is fixed to the light receiving surface side, that is, the upper surface side of imaging device 110, and vertical illumination 114 is arranged on lens 112 via box-shaped member 118. Vertical illumination 114 includes generally annular-shaped outer shell member 120, and outer shell member 120 has a shape that extends upward toward the outer edge. That is, outer shell member 120 has a shape in which the bottom portion of a bowl is removed, and is arranged in the upper end portion of box-shaped member 118 at the end portion on the side having the smaller inner diameter. Multiple LED lights 122 are provided inside of outer shell member 120, and the multiple LED lights 122 irradiate the upward with the vertical illumination light.

In addition, side illumination 116 is configured with six laser lights 124 (only two laser lights are shown in Fig. 5). Half of six laser lights 124 (three each) are arranged on the outside of both end portions facing rectangular plate member 126 arranged on the upper edge of outer shell member 120 of vertical illumination 114 in the direction of irradiating toward center portion of plate member 126 with the side illumination light. Each laser light 124 is installed on flange portion 120a provided on the outer surface of outer shell member 120.

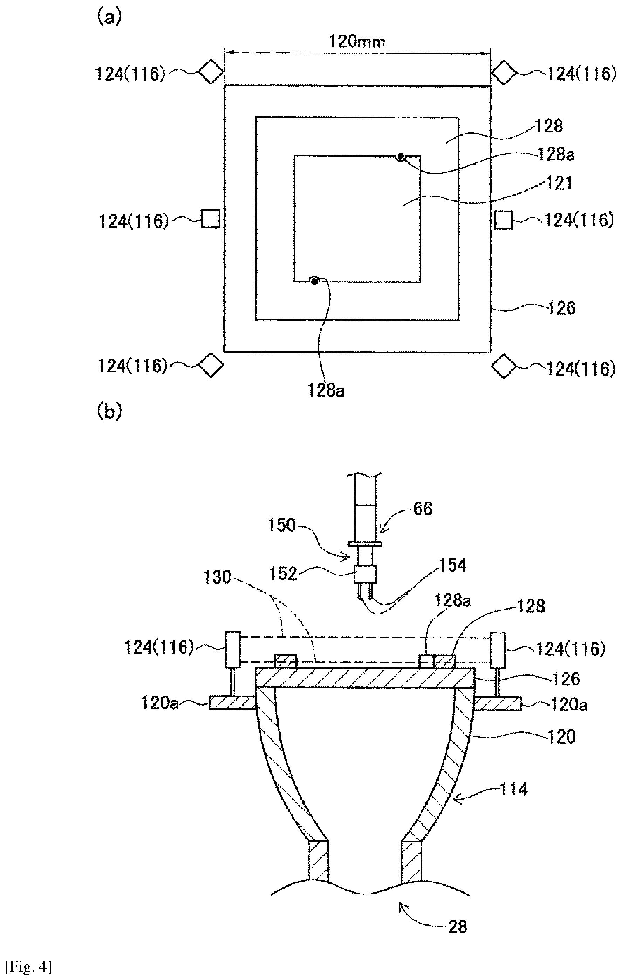

As shown in Fig. 4(a), plate member 126 is a member in which a part of the region including the center portion is transparent. In the present embodiment, the transparent region is formed in a rectangular shape, and for example, forms horizontal imaging region 121. Reference mark mounting plate 128 (for example, made of glass) is arranged on plate member 126 surrounding imaging region 121. Reference mark mounting plate 128 installs reference mark 128a in imaging region 121 in order to image reference mark 128a using part camera 28. In the present embodiment, reference mark mounting plate 128 has an outer shape formed in, for example, a rectangular shape, and a portion where imaging region 121 is positioned is cut off. However, reference mark 128a is printed on a portion protruding into imaging region 121 from inner end portion of reference mark mounting plate 128 such that reference mark 128a is imaged. Reference mark 128a is formed, for example, in a circular shape, and is printed on the front surface of reference mark mounting plate 128 in the present embodiment, but is not limited to this, and may be printed on the rear surface of reference mark mounting plate 128. The method of using reference mark 128a will be described later.

Six laser lights 124 irradiate toward the center of plate member 126 with the side illumination light in the generally horizontal direction. Then, the vertical illumination light by vertical illumination 114 or the side illumination light by side illumination 116 is reflected by an imaging target component and is incident on lens 112. Then, the light incident on lens 112 is incident on imaging device 110 and is detected by the imaging element of imaging device 110. As a result, the imaging target component is imaged by part camera 28.

Component supply device 30 is arranged at a first end portion in the front-rear direction of frame section 40. Component supply device 30 includes tray-type component supply device 78 and feeder-type component supply device (refer to Fig. 3) 80. Tray-type component supply device 78 is a device for supplying components in a state of being placed on a tray. Feeder-type component supply device 80 is a device for supplying components by a tape feeder or a stick feeder (not shown).

Bulk component supply device 32 is arranged at a second end portion in the front-rear direction of frame section 40. Bulk component supply device 32 is a device that aligns multiple components in a scattered state and supplies the components in the aligned state. That is, the device is a device that aligns the multiple components in any postures to a predetermined posture, and supplies the components having the predetermined posture. Examples of the components supplied by component supply device 30 and bulk component supply device 32 include electronic circuit components, components of a solar cell, components of a power module, or the like. In addition, examples of the electronic circuit components include components that have leads and components that do not have leads.

As shown in Fig. 3, control device 34 includes controller 82, multiple drive circuits 86, and image processing device 88. Multiple drive circuits 86 are connected to conveyance device 50, clamp device 52, work heads 60 and 62, work head moving device 64, tray-type component supply device 78, feeder-type component supply device 80, and bulk component supply device 32, respectively. Controller 82 includes CPU, ROM, RAM, and the like, and is mainly configured by a computer, which is connected to multiple drive circuits 86. As a result, the operation of t base material conveyance holding device 22, component mounting device 24, component supply device 30, and the like is controlled by controller 82. In addition, controller 82 is also connected to image processing device 88. Image processing device 88 processes the image data obtained by mark camera 26 and part camera 28, and controller 82 acquires various information from the image data.

### <Operation of Component Mounter>

In component mounter 10, by the configuration described above, the component mounting work is performed on circuit base material 12 held in base material conveyance holding device 22. In component mounter 10, various components can be mounted on circuit base material 12, but a case where lead component 150 having leads 154 (refer to Fig. 4(b) is mounted on circuit base material 12 will be described below.

Specifically, circuit base material 12 is conveyed to a work position, and is fixedly held by clamp device 52 at that position. Next, mark camera 26 moves above circuit base material 12 and images circuit base material 12. Then, controller 82 calculates the position coordinates and the like of an insertion hole (not illustrated) formed in circuit base material 12 in the XY-direction based on the image data.

In addition, component supply device 30 or bulk component supply device 32 supplies lead component 150 at a predetermined supply position. Then, any one of work heads 60 and 62 moves above a supply position of the component and holds lead component 150 by suction nozzle 66. As shown in Fig. 4(b), suction nozzle 66 picks up and holds lead component 150 on the upper surface of component main body portion 152 of lead component 150.

Next, work heads 60 and 62 holding lead component 150 move above part camera 28, and lead component 150 held by suction nozzle 66 is imaged by part camera 28. Then, controller 82 calculates the position coordinates of the tip of lead 154 of lead component 150 held by suction nozzle 66 in the XY-direction based on the image data.

Subsequently, work heads 60 and 62 holding lead component 150 move above circuit base material 12, and correct an error in the holding position of circuit base material 12 and an error in the holding position of lead component 150, and the like. Then, by lead component 150 being released by suction nozzle 66, lead component 150 is mounted on circuit base material 12.

### < Imaging of Lead Component by part camera>

As described above, in component mounter 10, lead component 150 supplied by component supply device 30 or the like is held by suction nozzle 66, and held lead component 150 is imaged. Then, the position coordinates of the tip of lead 154 in the XY-direction are calculated based on the image data, and lead 154 is inserted into the insertion hole of circuit base material 12 using the position coordinates of the tip of calculated lead 154.

Specifically, when lead component 150 held by suction nozzle 66 is imaged, as shown in Fig. 4 (b), work heads 60 and 62 move above part camera 28 by the operation of X-direction moving device 68 and Y-direction moving device 70 of work head moving device 64. Then, lead component 150 held by suction nozzle 66 is lowered by the operation of Z-direction moving device 72. At this time, the operation of Z-direction moving device 72 is controlled such that the tip of lead 154 of lead component 150 held by suction nozzle 66 falls within the irradiation range of side illumination 116 and within a depth of field of imaging device 110 (the range shown by a broken line in the drawing, hereinafter referred to as "vertical imaging range 130"). Here, the depth of field means a range of the distance between the subject in focus and the camera, and is also referred to as an imaging depth. When lead 154 of lead component 150 is imaged, only side illumination 116 is turned on and vertical illumination 114 is turned off in part camera 28.

As described above, when the tip of lead 154 of lead component 150 falls within vertical imaging range 130, the light of side illumination 116, that is, the laser light of laser light 124 is reflected by the tip of lead 154, and the reflection light is incident on imaging device 110 of part camera 28. As a result, the tip of lead 154 is imaged by imaging device 110. Then, controller 82 calculates the position coordinates of the tip of lead 154 in the XY-direction based on the image data obtained by imaging.

### <Imaging of Reference Mark by part camera>

Before or after imaging of lead component 150 by part camera 28, reference mark 128a is imaged by part camera 28. In the present embodiment, each of two reference marks 128a are arranged at points which are symmetrical positions with the center point of imaging region 121 as a target point. As shown in Fig. 4(b), since reference mark 128a is positioned within vertical imaging range 130, the light of side illumination 116, that is, the laser light of laser light 124, is reflected from the tip portion of reference mark 128a, and the reflection light is incident on imaging device 110 of part camera 28. As a result, the tip portion of reference mark 128a is imaged by imaging device 110. Then, controller 82 calculates the position coordinates of part camera 28 in the XY-direction based on the image data obtained by imaging.

As described above, since part camera 28 is arranged between base material conveyance holding device 22 and component supply device 30 on frame section 40 in a state of facing upward in a fixed manner, the position of part camera 28 does not change. However, due to the heat generated during the operation of component mounter 10, since errors may be contained in the image data, in order to correct the error, the position coordinates of part camera 28 is calculated, and the result of calculation is compared with the actual position coordinates of part camera 28.

### <Divided Capturing>

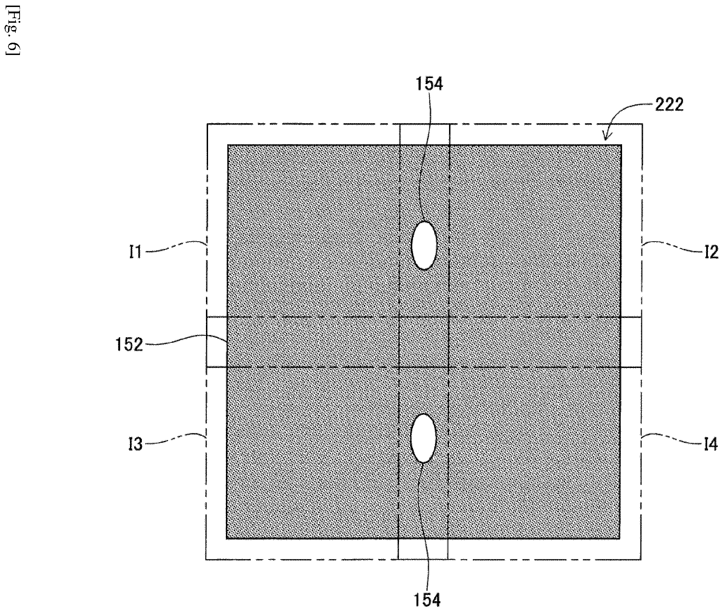

Next, a case where entire component main body portion 152 of lead component 150 held by suction nozzle 66 cannot be imaged by part camera 28 will be described. In such a case, for example, as shown in Fig. 6, component main body portion 152 of lead component 150 is divided into four regions I1, I2, I3, and I4, and each region I1, I2, I3, and I4 is imaged by part camera 28 to acquire four image data. Each of regions I1, I2, I3, and I4 is set such that a part thereof overlaps with each other.

The image data of each region I1, I2, I3, and I4 is referred to as divided data. Each divided data is combined by controller 82. By this combining, image data 222 of lead 154 of entire lead component 150 is created as shown in Fig. 6. Then, controller 82 calculates the position coordinates of the tip of lead 154 in the XY-direction based on image data 222.

As described above, in component mounter 10, even if lead component 150 held by suction nozzle 66 does not fall within the visual field of part camera 28, it is possible to specify the position coordinates of the tip of lead 154 of lead component 150 in the XY-direction.

When the tip of lead 154 of lead component 150 is divided to be imaged by part camera 28, each divided region is imaged while moving lead component 150 in the XY-direction by the operation of X-direction moving device 68 and Y-direction moving device 70 in a state in which the tip of lead 154 falls within vertical imaging range 130 (refer to Fig. 4(b)), and then, the image data of each region is acquired. In the conventional work machine described above, as described above in the "Technical Problem", since lead 154 of lead component 150 interferes with reference mark 228a, it is not possible to move lead component 150 having the size exceeding imaging region 121 in the XY-direction.

Therefore, in the present embodiment, as part camera 28, by adopting camera having lens 112 having a deep depth of field to expand vertical imaging range 130, even if lead component 150 is moved to the XY-direction in a state in which the tip of lead 154 falls within vertical imaging range 130, lead 154 of lead component 150 does not interfere with reference mark 128a. That is, even if the horizontal position of reference mark 128a and the imaging position of lead 154 of lead component 150 in the horizontal direction are different from each other, by adopting part camera 28 having lens 112 capable of imaging both reference mark 128a and lead 154, the problem that lead 154 interferes with reference mark 128a can be solved.

As a result, the size of lead component 150 of the work target, which is a maximum of 35 mm square when the divided capturing is not performed, can be expanded to a maximum of 50 mm square when the divided capturing is performed.

Furthermore, in the present embodiment, the interval between laser lights 124 in the X-direction is expanded from 70 mm (refer to Fig. 7(a)) in the conventional work machine described above to 120 mm (refer to Fig. 4(a)). The reason for this expansion is because, when lead component 150 having the larger size is moved to XY-direction for divided capturing, lead component 150 will interfere with laser light 124. However, in view of the problem in that the laser light of laser light 124 is reflected by the tip of lead 154, and the light amount of the reflection light incident on part camera 300 is reduced by expanding the interval between laser lights 124 in the X-direction, and imaging device 110 may not be able to image the tip of lead 154, in the present embodiment, the number of laser lights 124 is increased from 4 in the conventional work machine described above (refer to Fig. 7(a) to 6, and the light amount of the reflection light incident on part camera 300 can be maintained or increased. Furthermore, another reason for increasing the number of laser lights 124 is to cope with the following problems: the problem in that, since the number of lead 154 also increases as the size of the imaging target of lead component 150 increases, lead 154 to be imaged may be behind other leads 154 and may not be imaged, and the problem in that, since lead component 150 approaches laser light 124 when lead component 150 is moved to the XY-direction for divided imaging, the laser light will be blocked by lead component 150 and lead 154 to be imaged will not be imaged, and the like.

When the divided capturing is performed after expanding the interval of laser lights 124 as described above, the size of lead component 150 of the work target, which was a maximum of 50 mm square before the expansion, can be expanded to a maximum of 74 mm square.

As described above, component mounter 10 in the present embodiment includes work heads 60 and 62 having suction nozzles 66, X-direction moving device 68, Y-direction moving device 70 and Z-direction moving device 72 that move work heads 60 and 62 in the horizontal direction and up-down direction, part camera 28 having side illumination 116 that irradiates lead 154 of lead component 150 held in suction nozzle 66 with light from the side, and controller 82.

Controller 82 includes first imaging command section 160 that images at least one reference mark 128a provided at the end portion of the imaging range of part camera 28, first calculation section 162 that calculates the position of part camera 28 based on the image data captured by first imaging command section 160, lowering command section 164 that lowers work heads 60 and 62 such that lead 154 of lead component 150 held by suction nozzle 66 falls within an irradiation range of side illumination 116, second imaging command section 166 that images lead 154 of lead component 150 based on the reflection light of the side illumination 116 by lead 154 of lead component 150, and second calculation section 168 that calculates the position of lead 154 of lead component 150 based on the image data captured by second imaging command section 166, and reference mark 128a is provided at a position below the imaging position where lead 154 of lead component 150 is imaged, and part camera 28 has lens 112 capable of imaging both reference mark 128a and lead 154 of lead component 150.

As described above, in the component mounter 10 in the present embodiment, even if lead component 150 is moved in the horizontal direction when lead component 150 is imaged, since lead component 150 does not interfere with reference mark 128a, it is possible to calculate the position of lead 154 of lead component 150 having the larger size.

Incidentally, in the present embodiment, component mounter 10 is an example of the "work machine". Suction nozzle 66 is an example of the "component holding tool". Work heads 60 and 62 are examples of the "holding heads". X-direction moving device 68, Y-direction moving device 70 and Z-direction moving device 72 are examples of the "moving device". Lead component 150 is an example of the "component". Part camera 28 is an example of the "imaging device". Controller 82 is an example of the "control device".

In addition, side illumination 116 includes at least 6 laser lights 124, and half of laser light 124 among laser lights 124 are arranged outside of one end portion of the opposite both end portions of rectangular plate member 126 surrounding the imaging range of part camera 28 in the horizontal direction and half of laser lights 124 are arranged outside of the other end portion of the opposite both end portions of plate member 126 in the direction for irradiating toward the center portion of rectangular plate member 126 with the side illumination light.

As a result, even if lead component 150 is moved in the horizontal direction when lead component 150 is imaged, since lead component 150 does not interfere with side illumination 116, it is possible to calculate the position of lead 154 of lead component 150 having a larger size.

Incidentally, laser light 124 is an example of the "light source". Rectangular plate member 126 is an example of the "rectangular plane".

In addition, controller 82 further includes moving command section 170 that moves lead component 150 held by suction nozzle 66 in the horizontal direction in a state in which the positions of work heads 60 and 62 lowered by lowering command section 164 is held, third imaging command section 172 that images a part of lead 154 of lead component 150 based on the reflection light by lead 154 of lead component 150 after movement by moving command section 170, and data creation section 174 that combines the image data of a part of lead 154 of lead component 150 imaged by third imaging command section 172 and creates the image data of lead 154 of entire lead component 150, and second calculation section 168 calculates the position of lead 154 of lead component 150 based on the image data of lead 154 of entire lead component 150 created by data creation section 174.

As a result, it is possible to image lead 154 of lead component 150 having the size larger than the imaging range of part camera 28.

In addition, reference mark 128a is provided at an end portion of the imaging range of part camera 28 in the horizontal direction, and at a position below the imaging position for imaging lead 154 of lead component 150 in the horizontal direction, and lens 112 included in part camera 28 is a lens that can image both reference mark 128a and lead 154 of lead component 150 even if the position of reference mark 128a in the horizontal direction and the imaging position of lead 154 of lead component 150 in the horizontal direction are different from each other.
(1) In the embodiment described above, the number of laser lights 124 is six, but may be more than six.
(2) In the embodiment described above, the number of reference marks 128a is two, but may be one or more than two.

### Reference Signs List

10: component mounter, 28: part camera, 60 and 62: work head, 66: suction nozzle, 68: X-direction moving device, 70: Y-direction moving device, 72: Z-direction moving device, 82: controller, 112: lens, 116: side illumination, 121: imaging region, 128: reference mark mounting plate, 128a: reference mark, 124: laser light, 126: plate member, 150: lead component, 154: lead

## Claims

1. A work machine (10) comprising:
a holding head (60; 62) having a component holding tool (66);
a moving device (68; 70; 72) configured to move the holding head in a horizontal direction and an up-down direction;
an imaging device (110) having side illumination (116) configured to irradiate a lead (154) of a component (150) held in the component holding tool with light from a side; and
a control device (82),
**characterized in that** the control device includes:
a first imaging command section (160) configured to image at least one reference mark (128a) installed on a reference mark mounting plate (128) such that the at least one reference mark is provided in an end portion of an imaging range (121) of the imaging device in the horizontal direction and at a position below an imaging position where the lead of the component is imaged in the horizontal direction,
wherein the reference mark mounting plate is arranged on a plate member (126) surrounding the imaging range of the imaging device in the horizontal direction,
a first calculation section (162) configured to calculate a position of the imaging device based on image data captured by the first imaging command section,
a lowering command section (164) configured to lower the holding head such that the lead of the component held by the component holding tool falls within an irradiation range of the side illumination,
a second imaging command section (166) configured to image the lead of the component based on reflection light of the side illumination by the lead of the component, and
a second calculation section (168) configured to calculate a position of the lead of the component based on the image data captured by the second imaging command section, and
the imaging device includes a lens (112) configured to image both the reference mark and the lead of the component.

2. The work machine according to claim 1, wherein
the side illumination (116) includes at least 6 light sources (124), and
half of the light sources are arranged outside one end portion of opposite both end portions of a rectangular plate and
half of the light sources are arranged outside the other end portion of both end portions, in a direction for radiating side illumination light toward a center portion of the rectangular plate.

3. The work machine according to claim 1 or 2, wherein
the control device further includes
a moving command section (170) configured to move the component held by the component holding tool in the horizontal direction in a state in which a position of the holding head lowered by the lowering command section is held,
a third imaging command section (172) configured to image a part of the leads of the component based on the reflection light by the lead of the component after moving by the moving command section, and
a data creation section (174) configured to create image data of all the leads of the component by combining the image data of a part of the leads of the component imaged by the third imaging command section, and
wherein the second calculation section calculates the position of the lead of the component based on the image data of all the leads of the component created by the data creation section.

4. The work machine according to any one of claims 1 to 3, wherein
the reference mark is provided at an end portion of the imaging range of the imaging device in the horizontal direction, and at a position below the imaging position in the horizontal direction for imaging the lead of the component, and
the lens included in the imaging device is a lens configured to image both the reference mark and the lead of the component even if a position of the reference mark in the horizontal direction and the imaging position of the lead of the component in the horizontal direction are different from each other.

## Patentansprüche

1. Eine Arbeitsmaschine (10), aufweisend:
einen Haltekopf (60; 62) mit einem Komponentenhaltewerkzeug (66);
eine Bewegungsvorrichtung (68; 70; 72), die so konfiguriert ist, dass sie den Haltekopf in einer horizontalen Richtung und einer Auf-Ab-Richtung bewegt;
eine Bildgebungsvorrichtung (110) mit einer Seitenbeleuchtung (116), die so konfiguriert ist, dass sie einen Leiter (154) einer Komponente (150), der in dem Komponentenhaltewerkzeug gehalten wird, mit Licht von einer Seite bestrahlt; und
eine Steuervorrichtung (82),
**dadurch gekennzeichnet, dass** die Steuervorrichtung umfasst:
einen ersten Bildgebungsbefehlsabschnitt (160), der so konfiguriert ist, dass er mindestens eine Referenzmarke (128a) abbildet, die auf einer Referenzmarken-Montageplatte (128) installiert ist, so dass die mindestens eine Referenzmarke in einem Endabschnitt eines Bildgebungsbereichs (121) der Bildgebungsvorrichtung in horizontaler Richtung und an einer Position unterhalb einer Bildgebungsposition bereitgestellt wird, an der der Leiter der Komponente in horizontaler Richtung abgebildet wird,
wobei die Referenzmarken-Montageplatte auf einem Plattenelement (126) angeordnet ist, das den Abbildungsbereich der Abbildungsvorrichtung in horizontaler Richtung umgibt,
einen ersten Berechnungsabschnitt (162), der so konfiguriert ist, dass er eine Position der Abbildungsvorrichtung auf der Grundlage von Bilddaten berechnet, die durch den ersten Abbildungsbefehlsabschnitt erfasst werden,
einen Absenkbefehlsabschnitt (164), der so konfiguriert ist, dass er den Haltekopf so absenkt, dass die Leitung der von dem Komponentenhaltetool gehaltenen Komponente in einen Bestrahlungsbereich der Seitenbeleuchtung fällt,
einen zweiten Bildgebungsbefehlsabschnitt (166), der so konfiguriert ist, dass er den Leiter der Komponente basierend auf dem Reflexionslicht der Seitenbeleuchtung durch den Leiter der Komponente abbildet, und
einen zweiten Berechnungsabschnitt (168), der so konfiguriert ist, dass er eine Position des Leiters der Komponente basierend auf den Bilddaten berechnet, die durch den zweiten Bildgebungsbefehlsabschnitt erfasst werden, und
die Bildgebungsvorrichtung eine Linse (112) umfasst, die so konfiguriert ist, dass sie sowohl die Referenzmarke als auch den Leiter der Komponente abbildet.

2. Die Arbeitsmaschine nach Anspruch 1, wobei
die Seitenbeleuchtung (116) mindestens 6 Lichtquellen (124) umfasst und
die Hälfte der Lichtquellen außerhalb eines Endabschnitts von gegenüberliegenden beiden Endabschnitten einer rechteckigen Platte angeordnet ist und
die Hälfte der Lichtquellen außerhalb des anderen Endabschnitts von beiden Endabschnitten in einer Richtung zum Abstrahlen von seitlichem Beleuchtungslicht in Richtung eines Mittelabschnitts der rechteckigen Platte angeordnet ist.

3. Die Arbeitsmaschine nach Anspruch 1 oder 2, wobei
die Steuervorrichtung ferner umfasst
einen Bewegungsbefehlsabschnitt (170), der so konfiguriert ist, dass er die von dem Komponentenhaltewerkzeug gehaltene Komponente in einem Zustand, in dem eine Position des von dem Absenkbefehlsabschnitt abgesenkten Haltekopfes gehalten wird, in horizontaler Richtung bewegt,
einen dritten Bildgebungsbefehlsabschnitt (172), der so konfiguriert ist, dass er einen Teil der Anschlüsse des Bauelements basierend auf dem Reflexionslicht durch den Anschluss des Bauelements nach der Bewegung durch den Bewegungsbefehlsabschnitt abbildet, und
einen Datenerzeugungsabschnitt (174), der so konfiguriert ist, dass er Bilddaten aller Anschlüsse des Bauteils durch Kombinieren der Bilddaten eines Teils der Anschlüsse des Bauteils, die durch den dritten Bildgebungsbefehlsabschnitt abgebildet werden, erzeugt, und
wobei der zweite Berechnungsabschnitt die Position des Anschlusses des Bauteils auf der Grundlage der Bilddaten aller Anschlüsse des Bauteils, die durch den Datenerzeugungsabschnitt erzeugt werden, berechnet.

4. Die Arbeitsmaschine gemäß einem der Ansprüche 1 bis 3, wobei
die Referenzmarke an einem Endabschnitt des Abbildungsbereichs der Abbildungsvorrichtung in horizontaler Richtung und an einer Position unterhalb der Abbildungsposition in horizontaler Richtung zum Abbilden des Vorsprungs der Komponente vorgesehen ist und
die in der Abbildungsvorrichtung enthaltene Linse eine Linse ist, die so konfiguriert ist, dass sie sowohl die Referenzmarke als auch den Vorsprung der Komponente abbildet, selbst wenn eine Position der Referenzmarke in horizontaler Richtung und die Abbildungsposition des Vorsprungs der Komponente in horizontaler Richtung voneinander verschieden sind.

## Revendications

1. Machine de travail (10) comprenant :
une tête de maintien (60 ; 62) présentant un outil de maintien de composant (66) ;
un dispositif de déplacement (68 ; 70 ; 72) configuré pour déplacer la tête de maintien dans une direction horizontale et une direction haut-bas ;
un dispositif d'imagerie (110) présentant une illumination latérale (116) configuré pour irradier une broche (154) d'un composant (150) maintenu dans l'outil de maintien de composant avec une lumière provenant d'un côté ; et
un dispositif de commande (82),
**caractérisée en ce que** le dispositif de commande inclut :
une première section de commande d'imagerie (160) configurée pour prendre une image d'au moins une marque de référence (128a) installée sur une plaque de montage de marque de référence (128) de sorte que l'au moins une marque de référence est disposée dans une partie d'extrémité d'une plage d'imagerie (121) du dispositif d'imagerie dans la direction horizontale et sur une position au-dessous d'une position d'imagerie où la broche du composant fait l'objet d'une prise d'image dans la direction horizontale,
dans laquelle la plaque de montage de marque de référence est disposée sur un élément de plaque (126) entourant la plage d'imagerie du dispositif d'imagerie dans la direction horizontale,
une première section de calcul (162) configurée pour calculer une position du dispositif d'imagerie selon des données d'image capturées par la première section de commande d'imagerie,
une section de commande d'abaissement (164) configurée pour abaisser la tête de maintien de sorte que la broche du composant maintenue par l'outil de maintien de composant s'inscrive dans une plage d'irradiation de l'illumination latérale,
une deuxième section de commande d'imagerie (166) configurée pour prendre une image de la broche du composant selon une lumière de réflexion de l'illumination latérale par la broche du composant, et
une deuxième section de calcul (168) configurée pour calculer une position de la broche du composant selon les données d'image capturées par la deuxième section de commande d'imagerie, et
le dispositif d'imagerie inclut une lentille (112) configurée pour prendre une image à la fois de la marque de référence et de la broche du composant.

2. La machine de travail selon la revendication 1, dans laquelle
l'illumination latérale (116) inclut au moins 6 sources lumineuses (124), et
la moitié des sources lumineuses est disposée hors d'une partie d'extrémité de deux parties d'extrémité opposées d'une plaque rectangulaire et
la moitié des sources lumineuses est disposée hors de l'autre partie d'extrémité des deux parties d'extrémité, dans une direction pour un rayonnement d'une lumière d'illumination latérale vers une partie centrale de la plaque rectangulaire.

3. La machine de travail selon la revendication 1 ou 2, dans laquelle
le dispositif de contrôle inclut en outre
une section de commande de déplacement (170) configurée pour déplacer le composant maintenu par l'outil de maintien de composant dans la direction horizontale dans un état dans lequel une position de la tête de maintien abaissée par la section de commande d'abaissement est maintenue,
une troisième section de commande d'imagerie (172) configurée pour prendre une image d'une partie des broches du composant selon la lumière de réflexion par la broche du composant après un déplacement par la section de commande de déplacement, et
une section de création de données (174) configurée pour créer des données d'image de toutes les broches du composant en combinant les données d'image d'une partie des broches du composant prise en image par la troisième section de commande d'imagerie, et
dans laquelle la deuxième section de calcul calcule la position de la broche du composant selon les données d'image de toutes les broches du composant créées par la section de création de données.

4. La machine de travail selon l'une quelconque des revendications 1 à 3, dans laquelle
la marque de référence est disposée sur une partie d'extrémité de la plage d'imagerie du dispositif d'imagerie dans la direction horizontale, et à un emplacement au-dessous de la position d'imagerie dans la direction horizontale pour une imagerie de la broche du composant, et
la lentille incluse dans le dispositif d'imagerie est une lentille configurée pour prendre une image à la fois de la marque de référence et de la broche du composant même si une position de la marque de référence dans la direction horizontale et la position d'imagerie de la broche du composant dans la direction horizontale sont différentes l'une de l'autre.
